# EUROPEAN PATENT APPLICATION

(11) **EP 0 999 598 A1**
(43) Date of publication of application: **10.05.2000**
(21) Application number: 99121590.6
(22) Date of filing: 29.10.1999
(51) Int. Cl.: H01L 31/0224, H01L 31/18, H01L 31/0288

(54) **Solar cell and method for fabricating a solar cell**

(30) Priority: 04.11.1998 JP 31360098
(71) Applicant: SHIN-ETSU CHEMICAL CO., LTD., Chiyoda-ku Tokyo (JP)
(72) Inventor: Hirasawa, Teruhiko, Annaka-shi, Gunma-ken (JP); Tokunaga, Katsushi, Annaka-shi, Gunma-ken (JP)
(74) Representative: Wibbelmann, Jobst, Dr., Dipl.-Chem.

(57) **Abstract**

There is disclosed a method for fabricating a solar cell (10) comprising at least forming a phosphorus-containing junction layer (2) having a n⁺⁺ part (3) in which phosphorus is doped at high concentration on the front surface of a P type silicon substrate (1), forming a front surface electrode on the n⁺⁺ part, and forming a back surface electrode on the back surface of the P type silicon substrate, characterized in that the phosphorus-containing junction layer having the n⁺⁺ part (3) on the front surface is formed by printing an organic silica compound paste containing phosphorus on the P type silicon substrate in a pattern corresponding to a pattern of the front surface electrode (6), and subjecting the P type silicon substrate to vapor phase phosphorus diffusion heat treatment, and a solar cell fabricated by the method.

There can be provided a method for fabricating a solar cell having high efficiency in high productivity

## Description

### BACKGROUND OF THE INVENTION

### Field of the Invention:

The present invention relates to a method for fabricating a solar cell which has high conversion efficiency in high productivity.

### Description of the Related Art:

Conventionally, in view of the limited amounts of fossil fuels and the global warming effect induced by our large scale consumption of energy including fossil fuels, much attention has been paid to solar cells as means for producing clean energy, and studies have been performed for full-scale use of solar cells. Especially, structures and fabrication methods of solar cells employing silicon semiconductors have been studied earnestly in many countries.

In order to improve the energy conversion efficiency of the solar cell, it is important to reduce surface recombination loss. The front surface recombination loss is caused by extinction of minority carrier that is generated by photoabsorption and fundamentally contributes to photocurrent, as a result of recombination at a boundary surface of the front surface electrode or the back surface electrode of the solar cell. The problem of the surface recombination loss is serious especially in the case that electrodes are formed near the pn junction part for the recent tendency of the solar cell to be thin.

It is proposed to reduce the surface recombination loss by forming the part where impurity is doped at high concentration near the electrode to form energy barrier due to Fermi level difference (back surface field), and by bringing minority carriers going forward the electrode back to the side of the pn junction part.

It has also been proposed to reduce recombination due to the surface electron condition present on the surface of the semiconductor by forming an oxide film called a passivation oxide film on the front surface or the back surface of the semiconductor of the solar cell.

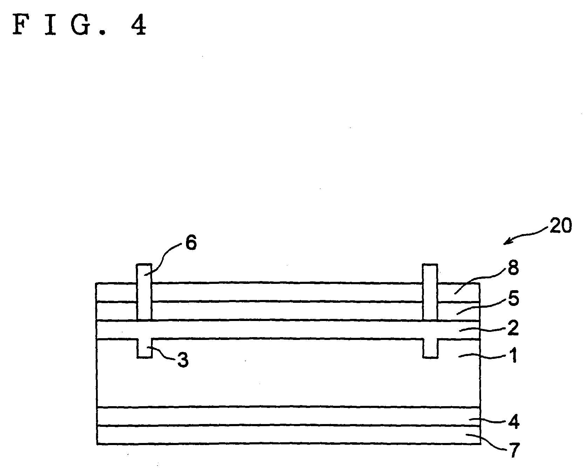

Fig.4 is a schematic view showing the conventional solar cell having the above-mentioned structure for reducing recombination loss. As shown in Fig.4, a phosphorus-containing junction layer 2 of the solar cell 20 has a n⁺⁺ part 3 where phosphorus is doped at high concentration on the front surface, and a front surface electrode 6 is formed on the n⁺⁺ part 3. At the boundary surface between the back surface of the P type silicon substrate 1 and the back surface electrode 7, a layered p⁺ part 4 in which aluminum is doped is formed.

Accordingly, an energy barrier due to Fermi level difference is formed, and reduction of recombination loss can be achieved.

On the part of the front surface of the phosphorus-containing junction layer 2 in which the front surface electrode 6 is not formed, a passivation oxide film 5 is formed, so that recombination on the surface of the phosphorus-containing junction layer 2 can be further reduced.

On the front surface of the solar cell 20, a reflection preventing film 8 consisting of silicon nitride is formed. On the entire back surface, a reflection layer consisting of silver having high reflectance is formed as a back surface electrode 7, so that light having long wave length may be kept in the solar cell to be utilized effectively.

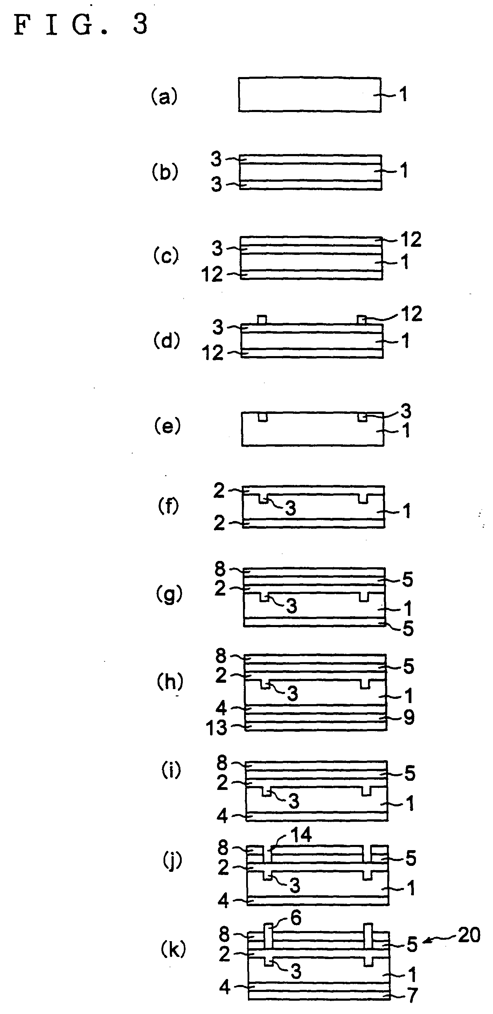

Conventionally, the solar cell having the above-mentioned structure has been fabricated by the following method. Fig.3 (a) to (k) is a flow chart showing one example of the method for fabricating the solar cell shown in Fig.4.

First, p-type silicon substrate 1 is prepared, and subjected to a mirror etching with alkali solution in order to remove a damaged layer formed during slicing, and then to RCA cleaning and IPA drying or the like (a).

Then, the layered n⁺⁺ part 3 in which phosphorus is doped at high concentration is formed on the both surfaces of the silicon substrate 1 by vapor phase phosphorus diffusion heat treatment (950°C) in POCl₃ atmosphere (b).

Then, the n⁺⁺ part 3 formed on the back surface is removed, and the silicon substrate 1 is subjected to thermal oxidation to form the oxide film for masking 12 on both surfaces (c).

Then, the unnecessary part is removed with HF through use of photo-lithograph, and the oxide film for masking 12 that covers the front surface electrode pattern remains (d).

Then, the silicon substrate 1 is subjected to texture process according to alkali anisotropic etching using the oxide film for masking 12 as an etching mask to form the n⁺⁺ part 3 selectively on the front surface of the silicon substrate 1. After the process, the oxide film for masking 12 is removed with HF (e).

Subsequently, phosphorus-containing junction layer 2 (n⁺) having n⁺⁺ part 3 on the front surface is formed by a second vapor phase phosphorus diffusion heat treatment using POCl₃ (800°C) on both surfaces of the silicon substrate 1 (f).

Then, the phosphorus-containing junction layer 2 formed on the back surface is removed, and the silicon substrate 1 is subjected to dry thermal oxidation to form a passivation oxide film 5. Then, the SiN reflection preventing film 8 is formed on the front surface by a plasma CVD method (g).

The oxide film 5 formed on the back surface is removed with HF. Then, aluminum paste 13 is printed on the entire back surface of the silicon substrate 1 through a screen printing method and dried, and the substrate is passed through a near-infrared lamp belt furnace (700°C) to form a layered p⁺ part 4 in which aluminum is doped at high concentration. (h)

Then, aluminum-silicon alloy layer 9 formed during aluminum firing and unnecessary aluminum paste 13 is removed with HCl (i).

Then, contact opening 14 is formed on the passivation film 5 and silicon nitride reflection preventing film 8 at the position corresponding to the front surface electrode pattern through use of photolithograph (j).

Finally, silver is deposited on the entire back surface to form the backside surface electrode 7. On the front surface, titanium, palladium and silver are deposited in the opening 14 in that order, and then the front surface electrode 6 is formed according to a lift off method, and subjected to anneal treatment in the atmosphere of nitrogen forming gas containing several % of hydrogen to provide the solar cell 20. (k).

Although the solar cell having low surface recombination loss and high efficiency can be fabricated according to the above-mentioned conventional method for fabrication, there are still problems of productivity and cost as follows.

In the process shown in Fig.3 (b) to (f), it is necessary to form the most suitable pn junction corresponding to the part where the front surface electrode is formed and the part where it is not formed, and a lot of process such as diffusion heat treatment, formation of oxide film for masking, formation of pattern, etching, the second diffusion heat treatment are necessary, and therefore the process for fabrication is complicated and inefficient. Furthermore, since high temperature heat treatment such as diffusion heat treatment, formation of oxide film for masking or the like is conducted repeatedly, the problem of the short lifetime of the silicon substrate is caused. In order to prevent shortening of the lifetime, it is necessary to strictly control cleanness of the heat treatment furnace, which may lower productivity.

As shown in Fig.3 (h), the p⁺ part where aluminum is doped all over the back surface is formed in the conventional method in order to reduce recombination on the back surface. However, thermal expansion coefficient is different between the silicon substrate and aluminum, which may result in warpage of the silicon substrate after the printing and firing process of the aluminum paste. The warpage of the substrate is significant in a thinner and larger substrate, and therefore damage and shortening of lifetime of the substrate due to the warpage has become serious problem.

In order to prevent the warpage of the substrate, it has been proposed that the p⁺ part where aluminum is doped is formed in a grid pattern, and that p⁺ part is formed by thermally diffusing boron. However, in the method of forming the p⁺ part in a grid pattern has a problem of a high recombination velocity in the part where p⁺ is not formed. In the method of thermally diffusing boron, lifetime of the silicon substrate may be shorten due to the high temperature diffusion heat treatment at 1100°C. Furthermore, in these method above, the efficiency of the solar cell fabricated according to the above-mentioned methods is lower than that fabricated according to the method wherein the p⁺ part in which aluminum is doped is formed on the entire back surface.

As shown in Fig.3(i), the metal film having high reflectance which also serves as back surface reflection layer, is formed as the back surface electrode in order to keep the light having long wave length. However, the reflectance of the aluminum-silicon alloy layer is low, and therefore, it is necessary to form the back surface reflection layer by vapor-depositing highly reflective metal after removing the aluminum - silicon alloy layer by etching. Such process is complicated and needs labor. Furthermore, lossy vapor deposition is performed using expensive silver, and thus results in increase of cost for the process.

As shown in Fig.3 (j),(k), the electrodes are formed according to a lift off method using photo lithographic method, which is complicated and inefficient. Furthermore, a great amount of resist and chemicals are used in the lift off method, and a great amount of electrode material such as silver is lost in the vapor-deposition method. Thus, yield is low and cost is extremely high in the above-mentioned methods.

As described above, the conventional method for fabricating solar cell wherein recombination loss is reduced is extremely complicated, and in such a method, yield is low, cost is high, and productivity is extremely low .

### SUMMARY OF THE INVENTION

The present invention has been accomplished to solve the above-mentioned problems, and an object of the invention is to provide a method for fabricating the solar cell wherein high productivity and cost performance are achieved by simplifying the process for fabricating the solar cell and reducing the material to be used for fabrication.

To achieve the above-mentioned object, the present invention provides a method for fabricating a solar cell comprising at least forming a phosphorus-containing junction layer having a n⁺⁺ part in which phosphorus is doped at high concentration on the front surface of a P type silicon substrate, forming a front surface electrode on the n⁺⁺ part, and forming a back surface electrode on the back surface of the P type silicon substrate, wherein the phosphorus-containing junction layer having the n⁺⁺ part on the front surface is formed by printing an organic silica compound paste containing phosphorus on the P type silicon substrate in a pattern corresponding to a pattern of the front surface electrode, and subjecting the P type silicon substrate to vapor phase phosphorus diffusion heat treatment.

As described above, when the phosphorus-containing junction layer is formed by printing the organic silica compound paste containing phosphorus on the P type silicon substrate in a pattern corresponding to the pattern of the front surface electrode, and by subjecting the P type silicon substrate to the vapor phase phosphorus diffusion heat treatment, the process can be significantly simplified, and productivity can be improved. Since only one diffusion heat treatment is necessary, shortening of the lifetime of the silicon substrate can be minimized, and it is not necessary to control cleanness of the heat treatment furnace so severely, as in the conventional method. Furthermore, a photo lithograph process for forming an electrode pattern can be omitted, so that reduction of cost for material can also be achieved.

Preferably, a passivation oxide film is formed on the front surface of the above-mentioned phosphorus-containing junction layer and the back surface of the P type silicon substrate.

As described above, when the passivation oxide film is formed on both of the front surface of the phosphorus-containing junction layer and the back surface of the P type silicon substrate, the effect of reducing recombination loss of the solar cell can be further improved, and the efficiency of the solar cell can be improved.

Preferably, after the passivation oxide film is formed on the back surface of the P type silicon substrate, a p⁺ part in a dot pattern in which aluminum is doped is formed on the back surface of the P type silicon substrate by printing an aluminum paste in a dot pattern on the passivation oxide film, and firing so that aluminum may pass through the passivation oxide film and may be diffused in silicon of the P type silicon substrate.

As described above, when the p⁺ part in a dot pattern is formed by printing an aluminum paste in a dot pattern on the passivation oxide film, after passivation oxide film is formed, and firing it so that the aluminum may pass through the passivation oxide film and may be diffused in silicon of the P type silicon substrate, warpage of the silicon substrate can be prevented without lowering the efficiency of the solar cell. Furthermore, since the aluminum paste is printed in a dot pattern, an amount of the paste to be used can be significantly reduced as compared with the conventional method wherein the paste is printed on the entire surface, so that cost for fabrication can be reduced.

After the above-mentioned p⁺ part in a dot pattern is formed, a silver paste can be preferably printed on the entire back surface of the P type silicon substrate, and fired to form the back surface electrode which also serves as the back surface reflection layer.

Since the p⁺ part on the passivation oxide film on the back surface is formed in a dot pattern, the occupied area is small enough to have no effect on the reflectance of the back surface, and therefore, it is not necessary to remove the aluminum - silicon alloy layer and the aluminum paste by etching. Accordingly, the back surface electrode which also serves as the reflection layer can be directly formed on the entire back surface of the silicon substrate, and thus the process can be simplified to further improve productivity.

Since the back surface electrode is formed not by conducting the conventional lossy vapor deposition method, but by printing silver paste directly and firing it, yield can be improved, the process can be simplified and the cost can be significantly reduced. Furthermore, since the back surface electrode which also serves as the reflection layer is formed directly on the passivation oxide film on the back surface, reflection can be achieved not only by the back surface electrode as in a conventional method, but also by the back surface passivation oxide film, and thus the reflection effect of the back surface can be totally improved.

After the passivation oxide film is formed on the front surface of the above-mentioned phosphorus-containing junction layer, a front surface reflection preventing film can be preferably formed on the passivation oxide film, and a silver paste can be printed at the position corresponding to the n⁺⁺ part of the phosphorus junction layer and fired so that the silver may pass through the surface reflection preventing film and the passivation oxide film and may be brought into contact with the phosphorus-containing junction layer, to form the front surface electrode on the n⁺⁺ part.

As described above, when the passivation oxide film and the surface reflection preventing film are formed on the front surface of the phosphorus-containing junction layer, the silver paste is directory printed at the position corresponding to the n⁺⁺ part of the phosphorus junction layer, and fired so that the silver may pass through the surface reflection preventing film and the passivation oxide film and may be brought into contact with the phosphorus-containing junction layer, to form the front surface electrode on the n⁺⁺ part, the photo lithograph process in the lift off method can be omitted, and therefore the process can be simplified, and the material used for photo lithograph can be saved. Furthermore, since the front surface electrode is formed not by conducting vapor deposition method wherein a lot of material is lost, but by directly printing silver paste and firing it, yield can be improved, and cost can be reduced significantly, as compared with the conventional method.

Preferably, when the silver paste is printed at a position corresponding to the above-mentioned n⁺⁺ part, the position to be printed can be determined depending on difference in color between n⁺⁺ part and the other part of the phosphorus-containing junction layer.

Since the passivation oxide film is formed differently in thickness between the n⁺⁺ part of the phosphorus-containing junction layer and the other part, and difference in color depending on the difference in thickness between n⁺⁺ part and the other part of the phosphorus-containing junction layer can be easily recognized. Accordingly, the front surface electrode can be formed in short time and at an accurate position corresponding to the n⁺⁺ part, so that productivity of the solar cell can be further improved.

The present invention also provides a method for fabricating a solar cell at least comprising forming a phosphorus-containing junction layer on the P type silicon substrate, then forming a front surface electrode on the front surface of phosphorus-containing junction layer, and forming a back surface electrode on the back surface of the P type silicon substrate, wherein, before the back surface electrode is formed, a passivation oxide film is formed on the back surface of the P type silicon substrate, an aluminum paste is printed on the passivation oxide film in a dot pattern and fired so that aluminum may pass through the passivation oxide film and may be diffused in silicon of the P type silicon substrate to form a p⁺ part in a dot pattern in which aluminum is doped on the back surface of the P type silicon substrate.

As described above, the method wherein the aluminum paste is printed on the passivation oxide film in a dot pattern and fired to form the p⁺ part in a dot pattern can be applied effectively whether n⁺⁺ part is formed on the phosphorus-containing junction layer or not.

The solar cells fabricated according to the above-mentioned methods are inexpensive and have high efficiency.

As described above, according to the present invention, significant simplification of the process and reduction of the material to be used can be achieved in fabrication of the solar cell, so that the solar cell having high efficiency can be fabricated in high productivity, and therefore, a solar cell can be fabricated at lower cost than the conventional method.

### BRIEF DESCRIPTION OF THE DRAWINGS

Fig.1 (A) to (G) is a flow chart showing an example of a method for fabricating a solar cell according to the present invention.
Fig.2 shows a schematic view of a solar cell fabricated according to the method for fabrication of the present invention.
Fig.3 (a) to (k) is a flow chart showing an example of a conventional method for fabricating a solar cell.
Fig.4 shows a schematic view of a conventional solar cell having a structure for reducing recombination loss.

### DESCRIPTION OF THE INVENTION AND EMBODIMENT

The present invention will now be described in detail, but the present invention is not limited thereto.

The present invention has been completed by solving the problems in fabrication of a solar cell having high efficiency, such as complicated processes, low yield, high fabrication cost or the like to provide a method for fabricating an efficient solar cell in high productivity.

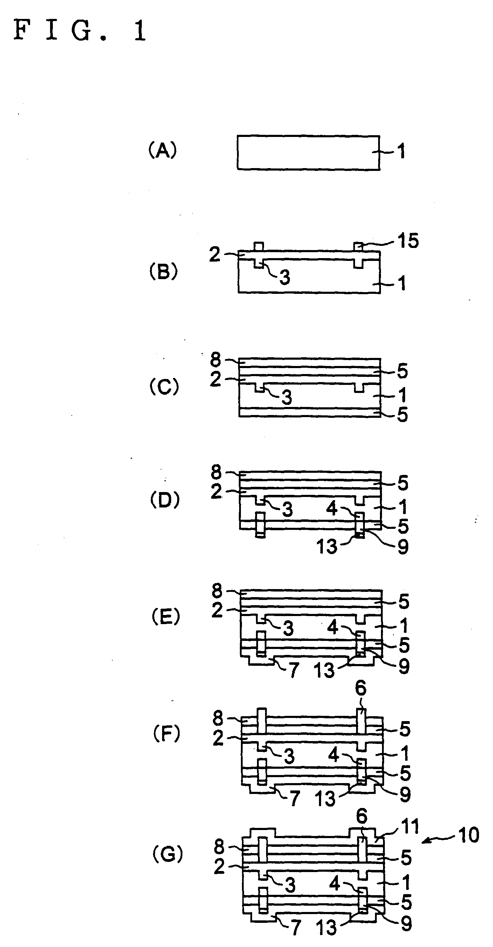

Fig.1 (A) to (G) is a flow chart showing an example of a method for fabricating a solar cell according to the present invention.

First, in a similar manner as the conventional method, P type silicon substrate 1 is prepared, and subjected to etching, cleaning or the like in order to remove the surface damage formed during a slicing process (A).

The organic silica compound paste containing phosphorus 15 is printed on the P type silicon substrate 1 in a pattern corresponding to a front surface electrode to be formed later. Then, the P type silicon substrate 1 is subjected to a vapor phase phosphorus diffusion heat treatment to form a phosphorus-containing junction layer 2 having a n⁺⁺ part 3 on the surface (B).

Then, an unnecessary phosphorus glass layer formed on the surface is removed, and the passivation oxide film 5 is formed on the front surface of the phosphorus-containing junction layer 2 and on the back surface of the P type silicon substrate 1. Furthermore, silicon nitride surface reflection preventing film 8 is formed on the passivation oxide film 5 on the front surface of the phosphorus-containing junction layer 2 (C).

After the passivation oxide film 5 is formed on the back surface of the P type silicon substrate 1, aluminum paste 13 is printed in a dot pattern on the passivation oxide film 5, and fired so that aluminum may pass through the passivation oxide film 5 and may be diffused in silicon of the P type silicon substrate, by which a p⁺ part 4 in a dot pattern in which aluminum is doped is formed on the back surface of P type silicon substrate 1 (D).

After the p⁺ part 4 in a dot pattern is formed without removing aluminum - silicon alloy layer 9 and aluminum paste 13 on the p⁺ part 4, silver paste is printed on the entire back surface of the P type silicon substrate 1, and fired to form a back surface electrode 7 which also serves as a back surface reflection layer (E).

The position to be printed is determined depending on the difference in color between n⁺⁺ part 3 and the other part of phosphorus-containing junction layer 2, and then the silver paste is printed at a position corresponding to the above-mentioned n⁺⁺ part 3, and fired so that the silver may pass through the silicon nitride surface reflection preventing film 8 and the passivation oxide film 5, and may be brought into contact with the phosphorus-containing junction layer 2 to form a front surface electrode 6 on the n⁺⁺ part 3 (F).

Finally, in order to increase the reflection preventing effect on the front surface, SiO₂ reflection preventing film 11 as the second reflection preventing layer is formed to complete the solar cell 10 of the present invention (G).

According to the present invention, as shown in Fig.1 (B), in formation of the phosphorus-containing junction layer, the phosphorus-containing junction layer having the n⁺⁺ part on its surface can be formed by the simple process wherein the organic silica compound paste containing phosphorus is printed in a pattern corresponding to a pattern of the front surface electrode and is subjected to the vapor phase phosphorus diffusion heat treatment once.

According to a conventional method, the phosphorus-containing junction layer is formed by very complicated process such as diffusion heat treatment, formation of oxide film for masking, formation of front surface electrode pattern, etching, the second diffusion heat treatment, and therefore, the productivity is low. Furthermore, a lot of material is used in two diffusion heat treatments, formation of front surface electrode pattern, and etching, resulting in high cost for fabrication. The two diffusion heat treatments may also cause shortening of lifetime of the substrate.

According to the present invention, since a minimal amount of silica compound containing phosphorus is printed on the substrate in a pattern corresponding to the electrode pattern, and the vapor phosphorus diffusion heat treatment is conducted once, phosphorus is diffused in high concentration and deeply at the position in contact with the silica compound. At the other position, phosphorus is diffused in low concentration and shallowly, since it is diffused according to vapor phase diffusion with atmosphere in the furnace. Therefore, it is possible to form the phosphorus-containing junction layer having a n⁺⁺ part formed selectively by single heat treatment process.

Accordingly, the process can be simplified significantly, shortening of lifetime of the substrate caused by single diffusion heat treatment is slight, and the labor for control of cleanness in the heat treatment furnace can be saved. Furthermore, as the process is simplified, the consumption of the material can be reduced, and thus yield can also be improved.

The above-mentioned organic silica compound paste can be prepared, for example, by adding a phosphorus impurity for diffusion such as P₂O₅ and SiP₂O₇ or the like, glass former, and organic binder as additives to an organic silicon compound represented by the formula: RnSi(OH)₄₋ₙ, and dissolving them into organic solvent (for example, consisting of alcohols as a main component, esters, ketones or the like).

According to the present invention, as shown in Fig.1(C), the passivation oxide film is formed both on the front surface of the phosphorus-containing junction layer and on the back surface of the P type silicon substrate.

According to the conventional method, the passivation oxide film is formed only on the front surface of the phosphorus-containing junction layer. However, with tendency of the silicon substrate to be thin, the number of minority carrier near the back surface of the silicon substrate increases, resulting in causing recombination loss due to absence of the back surface passivation oxide film on the back surface, and lowering of the efficiency of the solar cell.

According to the present invention, since both of the front surface of the phosphorus-containing junction layer and the back surface of the P type silicon substrate are covered with the passivation oxide film, recombination of the photo-generated minority carrier is sufficiently suppressed on both of the front surface and the back surface, and thus the efficiency of the solar cell can be improved.

According to the present invention characterized in that, as shown in Fig.1(D), after the passivation oxide film is formed on the back surface of the P type silicon substrate, aluminum paste is printed in a dot pattern on the passivation oxide film, and fired so that the aluminum may pass through the passivation oxide film and may be diffused in silicon of the P type silicon substrate, and thus p⁺ part in which aluminum is doped is formed in a dot pattern on the back surface of the P type silicon substrate.

According to the conventional method wherein the aluminum paste is printed on the entire back surface of the silicon substrate, and the layered p⁺ part is formed thereon, warpage of the silicon substrate may be caused after tiring due to difference of the thermal expansion coefficient between silicon and aluminum. The warpage of the substrate may lead to damage and shortening of the lifetime of the substrate. According to the method wherein the p⁺ part in which aluminum is doped is formed in a grid pattern, or the method wherein the p⁺ part is formed by thermally diffusing boron in order to reduce the warpage, effect of reducing recombination loss is lowered, and the efficiency of the solar cell is lowered.

According to the present invention, the passivation oxide film is formed on the back surface of the silicon substrate, and the p⁺ part in dot pattern in which aluminum is doped is formed in the back surface of the silicon substrate covered with the passivation oxide film, and therefore, the entire back surface is sufficiently passivated with the passivation oxide film and the p⁺ part in dot pattern, and the recombination loss can be sufficiently reduced, and high efficiency of the solar cell can be achieved. Besides, as the part on which aluminum is printed is a small area in a dot pattern, warpage of the substrate is rarely occurred. Furthermore, since aluminum paste is printed in a dot pattern, the amount of the aluminum paste to be used is significantly reduced as compared with the conventional method wherein the aluminum is printed on the entire surface, so that cost can be reduced. Furthermore, since the p⁺ part in dot pattern also serves as a back surface collector electrode, the back surface electrode can be formed easily.

The method of printing aluminum in a dot pattern on the passivation oxide film to form the p⁺ part can be applied whether n⁺⁺ part is formed on the phosphorus-containing junction layer or not.

According to the present invention, as shown in Fig. 1 (E), after the p⁺ part in a dot pattern is formed, a silver paste is printed on the entire back surface of the P type silicon substrate, and fired so that the back surface electrode which also serves as a back surface reflection layer may be formed.

According to a conventional method, since reflectance of the aluminum - silicon alloy layer and an aluminum paste formed by firing of the aluminum is low, it is necessary to remove these layers by etching and to form a layer of metal having high reflectance such as silver as a back surface reflection layer, and therefore, the process is complicated. Furthermore, since the electrode is formed by vapor-depositing silver in the method, material loss is large, and cost is high.

According to the present invention, since the p⁺ part in a dot pattern which also serves a back surface collector electrode and an aluminum-silicon alloy layer and an aluminum paste are formed on the passivation oxide film on the back surface of the silicon substrate, and an occupied area is small enough to give no effect on the reflectance of the back surface, it is not necessary to remove the aluminum - silicon alloy layer and the aluminum paste. Furthermore, since the back surface electrode is formed not by conventional silver vapor deposition, but by a method of printing and firing a silver paste in which material loss is small, yield is improved, process is simplified, and cost is reduced. Furthermore, since the reflection layer is formed on the passivation oxide film of the back surface having high reflectance, reflection effect can be achieved by both of the passivation oxide film on the back surface and the back surface electrode which also serves as reflection layer, back surface reflection effect is totally improved, as compared with the conventional reflection layer consisting of only one back surface reflection layer.

According to the present invention, as shown in Fig.1(F), after the passivation oxide film is formed on the front surface of the phosphorus-containing junction layer, the surface reflection preventing film is formed on the passivation oxide film, a silver paste is printed at the position corresponding to n⁺⁺ part of the phosphorus-containing junction layer and fired so that the silver may pass through the front surface reflection preventing film and the passivation oxide film and may be brought into contact with the phosphorus-containing junction layer to form the front surface electrode on the n⁺⁺ part. When the silver paste is printed at the position corresponding to the n⁺⁺ part, the position to be printed is determined depending on difference in color between the n⁺⁺ part of the phosphorus-containing junction layer and the other part.

According to the conventional method, in order to get contact with the phosphorus-containing junction layer, a contact opening has been formed on the passivation film on the front surface and on the reflection preventing film, at the position corresponding to the front surface electrode pattern by photolithograph, and then vapor-deposited electrode is positioned at the contact opening to conduct a lift off method. Accordingly, the process is complicated, productivity is low, and consumption of the material is large because of use of resist for photolithograph and material loss in vapor deposition, and therefore cost is high.

According to the present invention, the n⁺⁺ part on which the front surface electrode should be formed can be easily defined by difference in color depending on difference in thickness of the formed passivation oxide film between the n⁺⁺ part and the other part, and therefore, the front surface electrode pattern can be printed on the n⁺⁺ part easily and quickly, for example, in accordance with screen printing having a pattern recognition and positioning mechanism, or the like. Furthermore, since the silver is fired so that the silver may pass through the front surface reflection preventing film and the passivation oxide film and may be brought into contact with the phosphorus-containing junction layer, photo lithograph process can be omitted so that the process can be simplified and consumption of the material can be reduced. Furthermore, since the front surface electrode is formed not by the conventional vapor deposition method but by a silver paste printing and firing method, yield can be improved, and cost far fabrication can be significantly reduced.

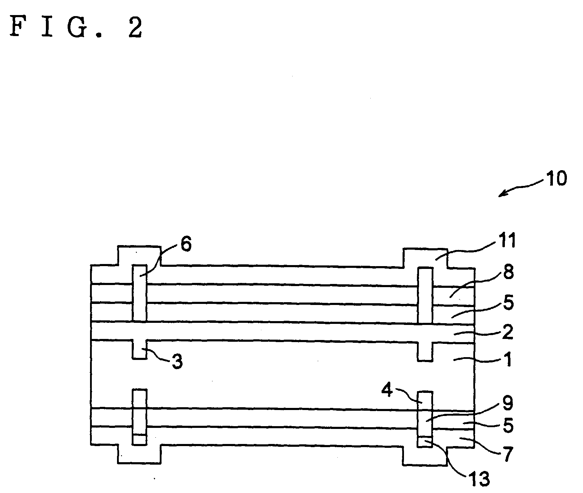

Fig.2 shows a schematic view of the solar cell fabricated according to the above-mentioned method for fabrication of the present invention. As shown in the figure, in the solar cell 10, the n⁺⁺ part 3 and the p⁺ part 4 are formed respectively on the part where the front surface electrode 6 and the back surface electrode 7 are formed, and the passivation oxide film formed on both of the front surface of the phosphorus-containing junction layer 2 and the back surface of the P type silicon substrate 1. Accordingly, significantly high effect of reducing recombination loss can be achieved. Furthermore, since the passivation oxide film 5 having high reflectance and the back surface electrode 7 which also serves as the back surface reflection layer are formed on the back surface of the P type silicon substrate 1, effect of keeping light is also high. Accordingly, the solar cell having extremely high efficiency can be obtained. Furthermore, since fabrication process can be significantly simplified as described above, productivity is extremely high as compared with the conventional method, so as to provide extremely cheap solar cells.

### EXAMPLE

The following example and comparative example are being submitted to further explain specific embodiment of the present invention. These examples are not intended to limit the scope of the present invention.

### (Example and Comparative Example)

A solar cell was fabricated by the method shown in Fig.1.

First, a P type silicon substrate 1 (electric resistance: 3 Ω · cm, thickness: 250 µm) was prepared, and mirror-etched with an alkaline solution in order to remove a damaged layer formed during slicing, and then subjected to RCA cleaning and IPA drying (Fig.1(A)).

Then, organic silica compound paste 15 containing phosphorus was printed on the front surface of P type silicon substrate 1 in a linear pattern corresponding to the pattern of the front surface electrode by a screen printing method, dried, and then passed through a near-infrared lamp belt furnace in order to be subjected to vapor phase phosphorus diffusion heat treatment (950°C) in a POCl₃ atmosphere, and thereby the phosphorus-containing junction layer 2 having the n⁺⁺ part 3 on its surface was formed at the part corresponding to the front surface electrode pattern (Fig.1(B)).

As the above-mentioned organic silica compound paste, the paste was prepared by dissolving the organic silicon compound represented by the formula: RₙSi(OH)₄₋ₙ in an organic solvent comprising alcohols as a main component, with adding P₂O₅ and SiP₂O₇ as a phosphorus impurity for diffusion, a glass former and organic binder.

The unnecessary phosphorus glass layer formed on the surface was removed with HF, and the passivation oxide film 5 was formed on the front surface of the phosphorus-containing junction layer 2 and the back surface of the P type silicon substrate 1 by dry thermal oxidation. Furthermore, on the passivation oxide film 5 on the surface of the phosphorus-containing junction layer 2, SiN surface reflection preventing film 8 was formed by plasma CVD (Fig.1(C)).

Then, an aluminum paste 13 was printed on the passivation oxide film 5 on the back surface of the P type silicon substrate 1, in a dot pattern, by a screen printing method, dried, and fired (700°C) through use of a near-infrared lamp belt furnace so that the aluminum may pass through the passivation oxide film 5 and may be diffused in silicon of the silicon substrate 1. Thereby, the p⁺ part 4 in a dot pattern in which aluminum was doped was formed on the back surface of the silicon substrate 1 covered with the passivation oxide film 5 (Fig.1 (D)).

Then, without removing the aluminum - silicon alloy layer 9 and aluminum paste 13 on the p⁺ part 4, a silver paste was printed on the entire back surface of the P type silicon substrate 1 by a screen printing method, dried, and tired (580°C) through use of a near-infrared lamp belt furnace, to form the back surface electrode 7 which also serves as a back surface reflection layer (Fig.1(E)).

Then, a silver paste was printed in a linear pattern corresponding to the n⁺⁺ part 3 as determined by difference in color between the n⁺⁺ part 3 and the other part on the phosphorus-containing junction layer 2, dried, and fired (580°C) through use of a near-infrared lamp belt furnace so that the silver may pass through the SiN front surface preventing film 8 and the passivation oxide film 5 and may be brought into contact with the phosphorus-containing junction layer 2. Thereby, a front surface electrode 6 was formed on the n⁺⁺ part 3 (Fig.1 (F)).

Finally, in order to improve the effect of preventing reflection on the front surface, SiO₂ reflection preventing film 11 was formed as the second reflection preventing film by atmospheric pressure CVD, to complete the solar cell 10 of the present invention (Fig.1(G))

The characteristics of the solar cell fabricated by the above-mentioned method were measured through use of a solar simulator modeled on natural sun light spectrum (Air Mass value: AM-1.5, total irradiance: 100 mW/cm², temperature: 25°C). For comparison, the solar cell was prepared using the same P type silicon substrate (substrate (electric resistance: 3 Ω · cm, thickness: 250 µm) as used in Example, by the method shown in Fig.3. The characteristics were measured in a similar manner to the above-mentioned manner, using the solar simulator. The results were shown in Table 1.

**Table 1**

| | short-circuit current (mA/cm²) | Open-circuit voltage (V) | Fill factor (%) | Conversion efficiency (%) |
|---|---|---|---|---|
| Example 1 | 37.7 | 0.656 | 0.795 | 19.7 |
| Comparative Example 1 | 37.6 | 0.638 | 0.809 | 19.4 |

As shown in Table 1, the solar cell of the present invention fabricated in Example is more excellent in conversion efficiency than the conventional solar cell fabricated in Comparative Example, namely the conversion efficiency of the former is 0.3 % higher than the latter, which means improvement of efficiency. The total number of the processes for fabrication of the solar cell of Example was nearly half of that of Comparative Example. The total time required for fabrication of the solar cell of Example was less than half of that of Comparative Example, since the diffusion heat treatment requiring long time was omitted. Furthermore, since neither photolithograph process nor deposition were conducted in the method of Example, the material to be used for the processes could be saved, and therefore significant cost reduction and improvement of yield could be achieved.

The present invention is not limited to the above-described embodiment. The above-described embodiment is a mere example, and those having the substantially same structure as that described in the appended claims and providing the similar action and effects are included in the scope of the present invention.

For example, the solar cell of the present invention achieves the above-described effects whether the silicon substrate is formed of a single crystal or polycrystal. Also, the effects of the present invention can be obtained even when the sequence of the steps of the fabrication method is changed or the detail process at each step is changed. Therefore, these modifications are included within the scope of the present invention.

## Claims

1. A method for fabricating a solar cell comprising at least forming a phosphorus-containing junction layer having a n⁺⁺ part in which phosphorus is doped at high concentration on the front surface of a P type silicon substrate, forming a front surface electrode on the n⁺⁺ part, and forming a back surface electrode on the back surface of the P type silicon substrate, characterized in that the phosphorus-containing junction layer having the n⁺⁺ part on the front surface is formed by printing an organic silica compound paste containing phosphorus on the P type silicon substrate in a pattern corresponding to a pattern of the front surface electrode, and subjecting the P type silicon substrate to vapor phase phosphorus diffusion heat treatment.

2. The method for fabricating a solar cell according to Claim 1 characterized in that a passivation oxide film is formed on the front surface of the above-mentioned phosphorus-containing junction layer and the back surface of the P type silicon substrate.

3. The method for fabricating a solar cell according to Claim 2 characterized in that, after the passivation oxide film is formed on the back surface of the P type silicon substrate, a p⁺ part in a dot pattern in which aluminum is doped is formed on the back surface of the P type silicon substrate by printing an aluminum paste in a dot pattern on the passivation oxide film, and firing so that aluminum may pass through the passivation oxide film and may be diffused in silicon of the P type silicon substrate.

4. The method for fabricating a solar cell according to Claim 3 characterized in that, after the above-mentioned p⁺ part in a dot pattern is formed, a silver paste is printed on the entire back surface of the P type silicon substrate, and fired to form the back surface electrode which also serves as the back surface reflection layer.

5. The method for fabricating a solar cell according to any one of Claims 2 to 4 characterized in that, after the passivation oxide film is formed on the front surface of the above-mentioned phosphorus-containing junction layer, a front surface reflection preventing film is formed on the passivation oxide film, and a silver paste is printed at the position corresponding to the n⁺⁺ part of the phosphorus junction layer and fired so that the silver may pass through the surface reflection preventing film and the passivation oxide film and may be brought into contact with the phosphorus-containing junction layer, to form the front surface electrode on the n⁺⁺ part.

6. The method for fabricating a solar cell according to Claim 5 characterized in that, when the silver paste is printed at a position corresponding to the n⁺⁺ part, the position to be printed is determined depending on difference in color between n⁺⁺ part and the other part of the phosphorus-containing junction layer.

7. A method for fabricating a solar cell at least comprising forming a phosphorus-containing junction layer on the P type silicon substrate, then forming a front surface electrode on the front surface of phosphorus-containing junction layer, and forming a back surface electrode on the back surface of the P type silicon substrate, characterized in that, before the back surface electrode is formed, a passivation oxide film is formed on the back surface of the P type silicon substrate, an aluminum paste is printed on the passivation oxide film in a dot pattern and fired so that aluminum may pass through the passivation oxide film and may be diffused in silicon of the P type silicon substrate to form a p⁺ part in a dot pattern in which aluminum is doped on the back surface of the P type silicon substrate.

8. A solar cell fabricated by the method according to any one of Claims 1 to 7.
